# EUROPÄISCHE PATENTSCHRIFT

(11) **EP 2 048 146 B1**
(45) Veröffentlichungstag und Bekanntmachung des Hinweises auf die Patenterteilung: **26.01.2011**
(21) Anmeldenummer: 08163461.0
(22) Anmeldetag: 02.09.2008
(51) Int. Cl.: C07F 9/00, H01L 21/285

(54) **Neue Tantal- und Niob-Verbindungen**
Novel tantalum and niobium compounds
Nouveaux composés de tantale et de niobium

(30) Priorität: 11.10.2007 DE 102007049015
(43) Veröffentlichungstag der Anmeldung: 15.04.2009
(73) Patentinhaber: H.C. Starck Clevios GmbH, 38642 Goslar (DE)
(72) Erfinder: Reuter, Knud, 47800 Krefeld (DE); Gaess, Daniel, Dr., 84489 Burghausen (DE); Sundermeyer, Jörg, 35041 Marburg (DE)
(74) Vertreter: Herzog, Martin

(56) Entgegenhaltungen:
- US-B2- 6 593 484
- BLEAU J E ET AL: "Molecular precursors for the CVD of niobium and tantalum nitride" POLYHEDRON, PERGAMON PRESS, OXFORD, GB, Bd. 24, Nr. 3, 17. Februar 2005 (2005-02-17), Seiten 463-468, XP025310189 ISSN: 0277-5387 [gefunden am 2005-02-17]
- FISCHER R.A. ET AL.: "Mixed hydrazido amido/imido complexes of tantulum, hafnium and zirconium" DALTON TRANSACTIONS, 2006, Seiten 121-128, XP002527277

## Beschreibung

Die vorliegende Erfindung betrifft spezielle, neue Tantal- und Niobverbindungen, die als Ausgangsstoffe für die Herstellung von Chemical Vapour Deposition (CVD) -Prekursoren dienen können.

Ta- sowie Ta-N-basierende Mischsystemschichten für die Anwendung in der Si-Mikroelektronik werden gegenwärtig durch plasmabasierende Abscheideverfahren (Physical Vapour Deposition PVD) hergestellt. Im Hinblick auf die extremen Anforderungen für immer höher integrierte Schaltkreise, z.B. der konformen Schichtabscheidung auf strukturierten Oberflächen, gelangen die PVD-Verfahren zunehmend an die Grenzen der technischen Realisierbarkeit. Für diese Anwendungen werden verstärkt chemische Gasphasenabscheidungen (Chemical Vapour Deposition CVD) bis hin zur Atomlagen-genauen Abscheidung mit einem Spezialverfahren der CVD, der sogenannten Atomic Layer Deposition (ALD), eingesetzt. Für diese CVD-Verfahren müssen naturgemäß für die jeweiligen gewünschten Schichten entsprechende chemische Ausgangsstoffe der einzelnen Elemente zur Verfügung stehen.

Zum gegenwärtigen Zeitpunkt werden für die CVD Ta-basierender Schichtstrukturen vorwiegend Halogenide, wie z.B. TaCl₅, TaBr₅, siehe WO 2000065123 Al, A. E. Kaloyeros et al., J. Electrochem. Soc. 146 (1999), S. 170-176, oder K. Hieber, Thin Salid Films 24 (1974), S.157-164) eingesetzt. Dies ist mit verschiedenen Nachteilen behaftet. Zum einen sind Halogenradikale vielfach aufgrund ihrer ätzenden/korrodierenden Eigenschaften für den Aufbau komplexer Schichtstrukturen unerwünscht, andererseits haben die Tantalhalogenide Nachteile durch ihre geringe Flüchtigkeit und die schwierige Verarbeitbarkeit als hochschmelzende Feststoffe. Einfache Tantal-V-amide, wie z.B. Ta(N(CH₃)₂)₅, werden ebenfalls vorgeschlagen, siehe z. B. Fix et. al., Chem. Mater., 5 (1993), S. 614-619. Mit den einfachen Amiden lassen sich aber meist nur bestimmte Zerlegungsverhältnisse von Ta zu N einstellen, die eine genaue Kontrolle der einzelnen Elementkonzentrationen in den Schichten erschweren. Vielfach bilden sich Ta -V-Nitridfilme (siehe z. B. Fix et al.: Ta₃N₅) und nicht die angestrebten elektrisch leitfähigen Ta-III-Nitridschichten (TaN). Zudem zeigen die mit diesen Ausgangsstoffen hergestellten Filme sehr oft hohe, unerwünschte Konzentrationen an Kohlenstoff. Tsai et. al., Appl. Phys. Lett. 67(8), (1995), S. 1128-1130 schlugen deshalb t-BuN=Ta(NEt₂)₃ in TaN-CVD bei 600 °C vor. Diese Verbindung bedarf wegen ihrer relativ geringen Flüchtigkeit einer hohen Anlagentemperatur und ist deshalb nicht sehr gut kompatibel mit den typischen Herstellungsprozessen integrierter Schaltkreise. Auch andere, ähnliche Tantalamidimide wurden vorgeschlagen, siehe z. B. Chiu et. al., J. Mat. Sci. Lett. 11 (1992), S. 96-98, womit jedoch ohne weiteres Reaktivgas hohe Kohlenstoffgehalte in den Tantalnitridschichten erzeugt wurden. In jüngerer Zeit wurden weitere Tantalnitrid-Prekursoren vorgeschlagen, z. B. durch Bleau et al., Polyhedron 24(3), (2005), S. 463 - 468, die wegen ihrer Komplexität und aufwendigen Herstellung von vornherein Nachteile aufweisen, oder spezielle Cyclopentadienylverbindungen, die entweder zwangsläufig zu TaSiN (nicht Tantalnitrid) führen oder einer zusätzlichen, nicht näher spezifizierten Stickstoffquelle bedürfen (Kamepalli et al., US Pat. Appl. Publ. 2004142555 A1, Prior. 2003-01-16, ATMI, Inc.). In US 6 593 484 (Kojundo Chemicals Laboratory Co., Ltd., Japan) wird ein geeignetes spezielles Tantalamidimid vorgeschlagen, wobei die angegebene Synthese jedoch schwierig und schlecht reproduzierbar ist. R. Fischer et al. beschreiben in Dalton Trans. 2006, 121 - 128 gemischte Hydrazido-Amido/Imido-Komplexe von Tantal, Hafnium und Zirkonium sowie deren Eignung in der CVD, jedoch ohne jegliche Angabe hinsichtlich des Ta:N-Verhältnisses im resultierenden Abscheideprodukt. In J. Chem. Soc. Dalton Trans. 1990, 1087 - 1091 wird ein Trichlorobis(trimethylhydrazidokomplex) beschrieben, jedoch fehlt jeglicher Hinweis auf dessen Verwendung in der CVD.

Diese Aussagen treffen im Wesentlichen bzw. sinngemäß auch auf die analogen NiobVerbindungen und die entsprechende CVD-Chemie zu.

Somit war ein erheblicher Bedarf nach weiteren, neuen Prekursoren für TaN- und NbN-Schichten vorhanden. Für manche Anwendungen kann auch der Wunsch nach alternativen Prekursoren bestehen, die für die entsprechende Anwendung geeigneter sind. Hierbei ist es vorteilhaft, Ausgangsstoffe bereitzustellen, welche eine Metall-Halogen-Bindung aufweisen, um die bekannte Reaktivität dieser Verbindungen gegenüber nucleophilen Reagenzien zur Herstellung der entsprechenden Prekursoren zu nutzen.

Somit bestand die Aufgabe der vorliegenden Erfindung darin, neue Ausgangsstoffe für Prekursoren bereitzustellen.

Die Erfindung betrifft Tantal- und Niobverbindungen, insbesondere Tantalverbindungen, mit einem zweiwertigen Hydrazido-Liganden der Formel (I), die diese Voraussetzungen erfüllen. Die Hydrazidoliganden sind solche der allgemeinen Formel 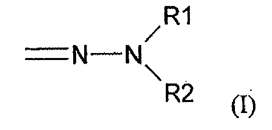 wobei
- R¹ und R²: unabhängig voneinander gegebenenfalls substituierte C₁- bis C₁₂-Alkyl-, C₅- bis C₁₂-Cycloalkyl-, C₆- bis C₁₀-Aryl-Reste, 1-Alkenyl-, 2-Alkenyl-, 3-Alkenyl bedeuten.

Gegenstand der Erfindung sind Verbindungen der allgemeinen Formel (II) 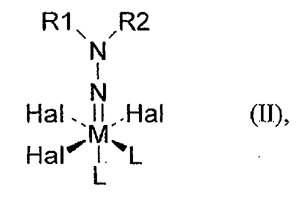 wobei
- M: für Nb oder Ta, bevorzugt für Ta steht,
- R¹ und R²: unabhängig voneinander für gegebenenfalls substituierte C₁- bis C₁₂-Alkyl-, C₅- bis C₁₂-Cycloalkyl-, C₆- bis C₁₀-Aryl-Reste, 1-Alkenyl-, 2-Alkenyl- und 3-Alkenylreste stehen,
- Hal: für Halogen aus der Gruppe F, Cl, Br, I, bevorzugt Cl und Br, besonders bevorzugt Cl, steht, und
- L: für einen über O, S oder N an das Metallatom koordinierenden organischen Komplexliganden steht.

Unter substituiert wird hier, wenn nicht anders erwähnt, eine Substitution mit C₁- bis C₄ - Alkoxy-oder Di (C₁- bis C₄ - Alkyl)amino-Resten verstanden.

**Alkyl** steht jeweils unabhängig für einen geradkettigen, cyclischen oder verzweigten Alkylrest, wobei die genannten Reste gegebenenfalls weiter substituiert sein können.

**C₁-C₁₂-Alkyl** steht im Rahmen der Erfindung beispielsweise für Methyl, Ethyl, n-Propyl, isoPropyl, 1-Ethylpropyl, 1,1-Dimethylpropyl, 1,2-Dimethylpropyl, 1,2-Dimethylpropyl, 1,1,2-Trimethylpropyl, 1,2,2-Trimethylpropyl, 1-Ethyl-1-methylpropyl, 1-Ethyl-2-methylpropyl, n-Butyl, sec,-Butyl, tert.-Butyl, 1-Methylbutyl, 2-Methylbutyl, 3-Methylbutyl, 1,1-Dimethylbutyl, 1,2-Dimethylbutyl, 1,3-Dimethylbutyl, 2,2-Dimethylbutyl, 2,3-Dimethylbutyl, 3,3-Dimethylbutyl, 1-Ethylbutyl, 2-Ethylbutyl, n-Pentyl, neo-Pentyl, 1-Methylpentyl, 2-Methylpentyl, 3-Methylpentyl, 4-Methylpentyl, n-Hexyl, n-Heptyl, n-Octyl, n-Nonyl, n-Decyl oder n-Dodecyl.

**1-Alkenyl, 2-Alkenyl, 3-Alkenyl** steht beispielsweise für die den vorangehenden Alkylgruppen entsprechenden Alkenylgruppen.

**C₅-C₁₂-Cycloalkyl** steht beispielsweise für gegebenenfalls substituierte mono-, bi- oder tricylische Alkylreste. Als Beispiele seien Cylopentyl, Cyclohexyl, Cycloheptyl, Pinanyl, Adamantyl oder die isomeren Menthyle genannt.

**Aryl** steht jeweils unabhängig für einen aromatischen Rest mit 6 bis 10 Gerüstkohlenstoffatomen, in denen keines, ein, zwei oder drei Gerüstkohlenstoffatome pro Cyclus durch Heteroatome, ausgewählt aus der Gruppe bestehend aus Stickstoff, Schwefel oder Sauerstoff, substituiert sein können, vorzugsweise jedoch für einen carbocyclischen aromatischen Rest mit 6 bis 10 Gerüstkohlenstoffatomen.

Beispiele für gegebenenfalls substituierte **C₆-C₁₀-Aryl** sind Phenyl, 2,6-Diisopropylphenyl, o-, p-, m-Tolyl oder Naphthyl.

Weiterhin kann der carbocyclische aromatische Rest oder heteroaromatische Rest mit bis zu fünf gleichen oder verschiedenen Substituenten pro Cyclus substituiert sein, die ausgewählt sind aus der Gruppe bestehend aus Fluor, Cyano, C₁-C₁₂-Alkyl, C₁-C₁₂-Fluoralkyl, C₁-C₁₂-Fluoralkoxy, C₁-C₁₂-Alkoxy oder Di(C₁-C₈-alkyl)amino.

Die Liganden L können gleiche oder verschiedene einzähnige Liganden darstellen. Sie können auch gemeinsam, über eine geeignete Brücke wie z. B. eine C₂-C₆-Alkylengruppe verbunden, einen zweizähnigen Liganden bilden. Solche Liganden dürfen wegen deren Reaktivität mit den am Metallatom gebunden Hal an den koordinierenden O-, S- bzw. N-Atomen keine freien H-Atome tragen. Somit sind Ether, Thioether oder tertiäre Amine bzw. N-Heterocyclen geeignete Verbindungsklassen für die Auswahl der Liganden L.

Geeignete über N koordinierende einzähnige Liganden sind z. B. Pyridin, Picoline. Geeignete über N koordinierenden zweizähnige Liganden sind z. B. Tetraalkylethylendiamine, wie N,N,N',N'-Tetramethylethylendiamin (TMEDA), N,N,N',N'-Tetramethyl-1,3-propan-diamin, Diimine (Diazabutadiene) wie N,N'-Dialkyl-1,4-diaza-1,3-diene [N,N'-Ethan-1,2-diylidenbisamine], die an N alkylsubstituiert sind und an den C-Atomen 2 und 3 H oder Alkylgruppen tragen können, Heterocyclen wie 2,2'-Dipyridyl.

Geeignete, über O koordinierende einzähnige Liganden sind z. B. Ether (Dialkylether wie Diethylether oder Methyl-tert-butylether), cyclische Ether wie z.B.Tetrahydrofuran (THF).
Geeignete über O koordinierende zweizähnige Liganden sind z. B. Ethylenglykol-diether wie Dimethoxyethan (DME), Diethoxyethan, längerkettige Ether wie 1,3-Dimethoxypropan.
Auch die Kombination beider Koordinationsmöglichkeiten ist denkbar, z. B. mit zweizähnigen Liganden wie 1-Dimethylamino-2-methoxyethan.
Geeignete, über S koordinierende einzähnige Liganden sind z. B. Thioether wie Diethylsulfid oder cyclische Thioether wie Tetrahydrothiophen.
Auch hier ist die Kombination zweier Koordinationsmöglichkeiten, wie z. B. mit O und S bzw. N und S enthaltenden zweizähnigen Liganden möglich.

Die wenigen Beispiele für Hydrazidokomplexe mit end-on-Struktur in der Literatur - insbesondere die Patentanmeldung von C. H. Winter et al., US 5591483 *-* belegen den technischen Wert gerade dieses Strukturmerkmals für die CVD.

Die folgenden Beispiele dienen der beispielhaften Erläuterung der Erfindung und sind nicht als Beschränkung aufzufassen.

### Beispiele:

Alle Operationen wurden unter Schutzgas (Stickstoff oder Argon) in dafür geeigneten Apparaturen (Schlenk-Technik oder Handschuhboxen) durchgeführt.

### Beispiel 1:

### Darstellung von Ta(NNMe₂)Cl₃ · 2Py

202 mg (0,56 mmol) Tantalchlorid wurden in 7 ml Toluol suspendiert und bei 60°C mit 0,1 ml Pyridin versetzt. Nach 10 Minuten (min) Rühren bei 60 °C wurden 115 mg (0,56 mmol) 1,1-Bis-(tri-methylsilyl)-2,2-dimethylhydrazin = (Me₃Si)₂NNMe₂ hinzugefügt. Nach weiteren 10 min bei 60 °C wurde die dunkelrote Lösung filtriert und das Filtrat mit dem doppelten Volumen Hexan überschichtet. Nach mehreren Tagen wurden die abgeschiedenen dunkelroten Kristalle isoliert und bei 0,1 mbar getrocknet. Ausbeute: 108 mg (0,21 mmol) entsprechend 38 % der Theorie (d. Th.).
¹H-NMR (C₆D₆, 200 MHz): δ (ppm) = 9,23 (bd, 2H, o-Py); 8,80 (m, 2H, o-Py); 6,81 (bt, 1H, *p*-Py); 6,64 (m, 1H, *p*-Py); 6,48 (bt, 2H, *m*-Py); 6,28 (m, 2H, *m*-Py), 3,10 (s, 6H, NN(C*H₃*)*₂*).
¹³C-NMR (C₆D₆, 50 MHz): δ (ppm) = 152,2; 124,2; 123,9; 47,2 (NN(C*H₃*)*₂*).

### Beispiel 2:

### Darstellung von Nb(NNMe₂)Cl₃ · 2Py

199 mg (0,74 mmol) Niob-V-chlorid wurden in 10 ml Toluol suspendiert und mit 154 mg (0,75 mmol) (Me₃Si)₂NNMe₂ versetzt. Nach 1 Stunde (h) Rühren wurden 2 ml Pyridin hinzugefügt und die Reaktionsmischung bei 23°C für weitere 16 h gerührt. Der ausgeschiedene braune Feststoff wurde abfiltriert und das grüne Filtrat mit dem doppelten Volumen Hexan überschichtet. Nach mehreren Tagen wurden die abgeschiedenen Kristalle isoliert und bei 0,1 mbar getrocknet. Ausbeute: 94 mg (0,23 mmol) entsprechend 31 % d. Th..
¹H-NMR (C₆D₆, 300 MHz): δ (ppm) = 9,29 (bd, 2H, o-Py); 8,79 (m, 2H, *o*-Py); 6,78 (bt, 1H, *p*-Py); 6,65 (m, 1H, *p*-Py); 6,46 (bt, 2H, *m*-Py); 6,30 (m, 2H, *m*-Py), 2,93 (s, 6H, NN(C*H₃*)*₂*).
¹³C-NMR (C₆D₆, 75 MHz): δ (ppm) = 152,1; 123,9; 123,8; 44,1 (NN(C*H₃*)*₂*).

| | | | | |
|---|---|---|---|---|
| Elementaranalyse (%, C₁₂H₁₆N₄Cl₃Nb) | theoretisch: | C 34,7; | H 3,9; | N 13,2 |
| | gefunden: | C 34,8; | H 3,9; | N 13,5 |

### Beispiel 3:

### Darstellung von Nb(NNMe₂)Cl₃ · DME

1264 mg (4,68 mol) Niob-V-chlorid wurden in 50 ml Toluol suspendiert und mit 968 mg (4,74 mmol) (Me₃Si)₂NNMe₂ versetzt. Nach 1 h Rühren wurden 7 ml 1,2-Dimethoxyethan (DME) hinzugefügt und die Reaktionsmischung unter Rühren für 3 h auf 90°C erhitzt. Nach Abkühlung auf 23°C wurde filtriert, das Filtrat auf das halbe Volumen eingeengt und mit dem doppelten Volumen Hexan überschichtet. Nach 16 h wurden die abgeschiedenen Kristalle isoliert und bei 0,1 mbar getrocknet. Ausbeute: 843 mg (2,43 mmol) entsprechend 52 % d. Th..
¹H-NMR (C₆D₆, 300 MHz): δ (ppm) = 3,49 (s, 3H, OC*H₃*); 3,36 (s, 3H, OC*H₃*); 3,06 (m, 4H, OC*H₂*C*H₂*O); 2,74 (s, 6H, N(C*H₃*)₂).
¹³C-NMR (C₆D₆, 75 MHz): δ (ppm) = 74,3 (OCH₃); 67,1 (OC*H₃*); 61,8 (OC*H₂*C*H₂*O); 43,9 (NN(C*H₃*)*₂*).

| | | | | |
|---|---|---|---|---|
| Elementaranalyse (%, C₆H₁₆N₂O₂Cl₃Nb) | theoretisch: | C 20,8; | H 4,7; | N 8,1 |
| | gefunden: | C 20,0; | H 4,6; | N 8,1 |

### Beispiel 4:

### Darstellung von Ta(NNMe₂)Cl₃ · TMEDA

2007 mg (5,60 mol) Tantalchlorid wurden in 150 ml Toluol suspendiert und bei 70°C mit 1162 mg (5,63 mmol) (Me₃Si)₂NNMe₂ versetzt. Nach 3 h Rühren wurde 1 ml N,N,N',N'-Tetra-methyl-ethylendiamin (TMEDA) hinzugefügt und die Reaktionsmischung für weitere 16 h bei 70 °C gerührt. Nach Abkühlung auf 23 °C wurde filtriert und das Filtrat mit dem doppelten Volumen n-Hexan überschichtet. Nach mehreren Tagen wurden die abgeschiedenen violetten Kristalle isoliert und bei 0,1 mbar getrocknet. Ausbeute: 1,09 g (2,36 mmol) entsprechend 42 % d. Th.
¹H-NMR (C₆D₆, 300 MHz): δ (ppm) = 2,87 (s, 6H, NN(C*H₃*)*₂*); 2,58 (s, 6H, N(C*H₃*)*₂*); 2,47 (2 d, 6H, N(C*H₃*)*₂*); 1,93 (bm, 4H, C₂*H₄*).
¹³C-NMR (C₆D₆, 75 MHz): δ (ppm) = 59,1; 57,3; 54,6; 50,1; 47,0.

| | | | | |
|---|---|---|---|---|
| Elementaranalyse (%, C₈H₂₂N₄Cl₃Ta) | theoretisch: | C 20,82; | H 4,82; | N 12,14 |
| | gefunden: | C 20,96; | H 4,80; | N 12,15 |

### Beispiel 5:

### a) Darstellung von Li[(iPrN)₂CNMe₂]

1,444 g (28,31 mmol) LiNMe₂ wurden in 50 ml THF vorgelegt und bei 0 °C mit 3,589 g (28,43 mmol) Diisopropylcarbodiimid versetzt. Nach 10 min wurde auf 23 °C erwärmt und 1 h gerührt. Die Reaktionslösung wurde bis zur Trockne eingeengt, der Abdampfrückstand aus THF umkristallisiert und die erhaltenen farblosen Kristalle im Vakuum getrocknet. Ausbeute: 4,01 g (22,6 mmol; 80 % d. Th.).

### b) Darstellung von Li[ⁱPrN)₂CCH₂SiMe₃]

103 mg (1,09 mmol) LiCH₂SiMe₃ wurden in 10 ml Toluol vorgelegt und mit 140 mg (1,10mmol) Diisopropylcarbodiimid versetzt. Nach 16 h Rühren bei 23 °C wurde die Lösung bis zur Trockne eingeengt und der Abdampfrückstand aus THF umkristallisiert. Die so erhaltenen farblosen Kristalle wurden im Vakuum getrocknet. Ausbeute: 208 mg (0,94 mmol; 86 % d. Th.).

### Beispiel 6:

### a) Darstellung von Ta(NNMe₂)[(ⁱPrN)₂CNMe₂]₂Cl aus Ta(NNMe)₂Cl₃ · 2Py

200 mg (0,39 mmol) Ta(NNMe)₂Cl₃ · 2Py, hergestellt entsprechend Beispiel 1, und 141 mg (0,79 mmol Li[(ⁱPrN)₂CNMe₂] hergestellt gemäß Beispiel 5a) wurden vermischt und bei - 78 °C mit 7 ml THF der gleichen Temperatur versetzt. Während 16 h wurde die Mischung unter Rühren auf 23 °C erwärmt. Die dunkel-orange Lösung wurde bei 20 mbar zur Trockne eingeengt, in 7 ml Hexan aufgenommen und filtriert. Das Filtrat wurde bei 20 mbar zur Trockne eingeengt und der Rückstand bei 10⁻³ mbar und 100 °C sublimiert. Ausbeute: 105 mg (0,17 mmol; 44 % d. Th.) als leuchtend orangefarbener Feststoff; Schmelzpunkt (Schmp). 166 °C.
¹H-NMR (C₆D₆, 300 MHz, 300 K): δ (ppm) = 5,0 - 3,7 (m, 4H, NC*H*(CH₃)₂); 2,89 (s, 6H, NN(C*H₃*)₂); 2,7 - 2,3 (12H, CN(C*H*₃)₂); 1,75 - 1,00 (m, 24 H, NCH(C*H*₃)₂).
¹H-NMR (D₈-Toluol, 500 MHz, 230 K): δ (ppm) = 4,04 (m, 1H, NC*H*(CH₃)₂); 3,92 (m, 2H, NC*H*(CH₃)₂); 3,79 (m, 1H, NC*H*(CH₃)₂); 2,92 (s, 6H, NN(C*H*₃)₂); 2,44 (6H, CN(C*H*₃)₂), 2,37 (6H, CN(C*H*₃)₂); 1,77 (bm, 9H, NCH(C*H*₃)₂); 1,69 (d, 3H, NCH(C*H*₃)₂); 1,58 (d, 3H, NCH(C*H*₃)₂); 1,35 (d, 3H, NCH(C*H*₃)₂); 1,27 (d; 3H, NCH(C*H*₃)₂); 1,08 (d, 3H, NCH(C*H*₃)₂).
¹³C-NMR (C₆D₆, 75 MHz, 300 K): δ (ppm) = 48,3 (NN(*C*H₃)₂); 47,3 (N*C*H(CH₃)₂); 39,8 (CN(*C*H₃)₂); 25,1 (NCH(*C*H₃)₂). Das Signal des quartären C-Atoms des Guanidinatoliganden ist wegen der Dynamik des Moleküls nicht zu sehen.

| | | | | |
|---|---|---|---|---|
| Elementaranalyse (%, C₂₀H₄₆N₈ClTa) | theoretisch: | C 39,06; | H 7,54; | N 18,22 |
| | gefunden: | C 38,38; | H 7,02; | N 17,61 |

EI-MS: 614 Ta(NNMC₂)[(ⁱPrN)₂CNMe₂]₂C]⁺, 20; 556 Ta[(ⁱPrN)₂CNMe₂]₂Cl⁺, 0,1; 362 Ta(ⁱPrN)₂CNMe₂Cl⁺, 70; 171 H(ⁱPrN)₂CNMe,⁺, 10; 1268 ⁱPrNCNⁱPr⁺, 12; 114 H₂CN(CH₃)NNN(CH₃)CH₂⁺, 50; 69 ⁱPrNC⁺ 100; 58 NNMe₂⁺, 75; 44 NMe₂⁺, 30.
IR (Nujolverreibung): 1564m, 1518b, 1411m, 1342m, 1325w, 1263m, 1197m, 1141m, 1055s, 1018w, 896m, 800b, 738m, 721m, 597w, 547w.

### Beispiel 7

### Darstellung von Ta(NNMe₂)[(ⁱPrN)₂CCH₂SiMe₃]₂Cl aus Ta(NNMe)₂Cl₃ · 2Py

702 mg (1,39 mmol) Ta(NNMe)₂Cl₃ · 2Py, hergestellt entsprechend Beispiel 1, und 622 mg (2,82 mmol Li[(ⁱPrN)₂CCH₂SiMe₃] hergestellt entsprechend Beispiel 5b) wurden in 15 ml Toluol vermischt und bei 23 °C 16 h gerührt. Die Lösung wurde bei 20 mbar zur Trockne eingeengt und der Rückstand mit 15 ml Hexan extrahiert. Der Extrakt wurde bei 20 mbar zur Trockne eingeengt und der ölige Rückstand bei 10⁻⁴ mbar und 100 °C destilliert. Ausbeute: 383 mg (0,54 mmol; 39 % d. Th.) als orangerotes, viskoses Öl.
¹H-NMR (C₆D₆, 300 MHz, 300 K): δ (ppm) = 3,7 - 3,5 (bm, 4H, NC*H*(CH₃)₂); 2,80 (s, 6H, NN(C*H*₃)₂); 1,76 (s, 4H, C*H*₂Si(CH₃)₃); 1,60 - 1,20 (bm, 24 H, NCH(C*H*₃)₂); 0,08 (s, 18 H, CH₂Si(C*H*₃)₃).
¹H-NMR (D₈-Toluol, 500 MHz, 260 K): δ (ppm) = 3,96 (m, 1H, NC*H*(CH₃)₂); 3,82 (m, 1H, NC*H*(CH₃)₂), 3,72 (m, 1H, NC*H*(CH₃)₂); 3,61 (m, 1H, NC*H*(CH₃)₂); 2,87 (s, 6H, NN(C*H*₃)₂); 1,74 (s, 2H, C*H*₂Si(CH₃)₃); 1,72 (d, 3H, NCH(C*H*₃)₂); 1,70 (s, 2H, C*H*₂Si(CH₃)₃); 1,68 (d, 3H, NCH(C*H*₃)₂); 1,64 (d, 3H, NCH(C*H*₃)₂); 1,60 (d, 3H, NCH(C*H*₃)₂); 1,56 (d, 3H, NCH(C*H*₃)₂); 1,35 (d, 3H, NCH(C*H*₃)₂); 1,26 (d, 3H, NCH(C*H*₃)₂); 1,09 (d, 3H, NCH(C*H*₃)₂); 0,11 (s, 9 H, CH₂Si(C*H*₃)₃); 0,08 (s, 9 H, CH₂Si(C*H*₃)₃).
¹³C-NMR (C₆D₆, 75 MHz, 300 K): δ (ppm) = 48,6 (NN(*C*H₃)₂); 25,7 - 23,3 (N*C*H(CH₃)₂); 16,6 (N₂C*C*H₂Si(CH₃)₃); - 0,2 (N₂CCH₂Si(*C*H₃)₃), Das Signal des quartären C-Atoms des Amidinatoliganden ist wegen der Dynamik des Moleküls nicht zu sehen.

| | | | | |
|---|---|---|---|---|
| Elementaranalyse (%, C₂₄H₅₆N₆ClSi₂Ta) | theoretisch: | C 41,10; | H 8,05; | N 11,98 |
| | gefunden: | C 40,96; | H 7,86; | N 11,88 |

EI-MS: 700 Ta(NNMe₂)[(ⁱPrN)₂CCH₂SiMc₃]₂Cl⁺, 5; 628 [M-SiMe₃]⁺ 6; 213 (ⁱPrN)₂CCH₂SiMe₃⁺, 5; 142 H(ⁱPrN)₂CCH₃⁺, 53; 126 ⁱPrNCNⁱPr⁺, 12; 114 H₂CN(CH₃)NNN(CH₃)CH₂⁺, 50; 73 SiMe3+, 24; 58 NNMe₂⁺, 75; 44 NMe₂⁺, 30.
IR (Nujolverreibung): 1560w, 1552w, 1313wb, 1261m, 1215m, 1178w, 1145m, 1097b, 1018b, 850m, 837m, 798mb, 721s, 597w, 567w, 526w.

### Beispiel 8

### Darstellung von Nb(NNMe₂)[(ⁱPrN)₂(CNMe₂]₂Cl aus Nb(NNMe)₂Cl₃ · 2Py

300 mg (0,72 mmol) Nb(NNMe)₂Cl₃ · 2Py, hergestellt entsprechend Beispiel 2, und 258 mg (1,45 mmol) Li[(ⁱPrN)₂CNMe₂] hergestellt gemäß Beispiel 5a) wurden bei 23 °C mit 7 ml THF versetzt und 16 h gerührt. Dabei verfärbte sich die zunächst grüne Lösung dunkelrot. Die Lösung wurde bei 20 mbar zur Trockne eingeengt, mit 7 ml Hexan extrahiert, und anschließend der Erxtrakt bei 20 mbar bis auf 1 ml eingeengt. Daraus fielen bei - 78 °C 175 mg (0,33 mmol; 46 % d. Th.) des Produkts als rote Kristalle aus; Schmp. 114 °C.
¹H-NMR (C₆D₆, 300 MHz, 300 K): δ (ppm) = 3,9 - 3,6 (m, 4H, NC*H*(CH₃)₂); 2,82 (s, 6H, NN(C*H*₃)₂); 2,46 - 2,36 (12H, CN(C*H*₃)₂); 1,77 - 1,00 (m, 24 H, NCH(C*H*₃)₂).
¹³C-NMR (C₆D₆, 75 MHz, 300 K): δ (ppm) = 166,8 (*C*N₃); 47,7 - 45,9 (NN(*C*H₃)₂), (N*C*H(CH₃)₂); 39,8 (N₂CN(*C*H₃)₂); 25,4 - 25,1 (NCH(*C*H₃)₂).

| | | | | |
|---|---|---|---|---|
| Elementaranalyse (%, C₂₀H₄₆N₈ClNb) | theoretisch: | C 45,85; | H 8,80; | N 21,26 |
| | gefunden: | C 44,39; | H 8,75; | N 21,14 |

EI-MS: 528 M⁺, 55; 170 (ⁱPrN)₂CNMe₂⁺, 55.
IR (Nujolverreibung): 1637s, 1562m, 1518w, 1410m, 1342w, 1315w, 1259s, 1194m, 1097bm, 1057s, 1020bm, 893s, 800bs, 738w, 721m, 605w, 574w, 542w.

### Beispiel 9:

### Darstellung von Nb(NNMe₂)[(ⁱPrN)₂CCH₂SiMe₃]₂Cl aus Nb(NNMe)₂Cl₃ · 2Py

3,66 g (8,80 mmol) Nb(NNMe)₂Cl₃ · 2Py, hergestellt entsprechend Beispiel 2, und 3,88 g (17,60 mmol Li[(ⁱPrN)₂CCH₂SiMe₃] hergestellt gemäß Beispiel 5a) wurden bei 0°C mit 40 ml vorgekühltem THF versetzt und bei 0°C 20 min gerührt. Im Anschluss wurde das Kühlbad entfernt und für weitere 12 h bei 23 °C gerührt. Die Lösung wurde bei 20 mbar zur Trockne eingeengt und der Rückstand mit insgesamt 40ml Hexan zweimal extrahiert. Die vereinigten Extrakte wurden bei 20 mbar zur Trockne eingeengt und der Rückstand bei 10⁻⁴ mbar und 130 °C Badtemperatur destilliert. Ausbeute: 700 mg (1,14 mmol; 13 % d. Th.) als dunkles Öl.
¹H-NMR (C₆D₆, 300 MHz, 300 K): δ (ppm) = 3,62 (m, 4H, NC*H*(CH₃)₂); 2,80 (s, 6H, NN(C*H*₃)₂); 1,76 (s, 4H, C*H*₂Si(CH₃)₃); 1,55 - 1,23 (m, 24 H, NCH(C*H*₃)₂); 0,08 (s, 18 H, CH₂Si(C*H*₃)₃).
¹³C-NMR (C₆D₆, 75 MHz, 300 K): δ (ppm) = 49,0 (b, NN(*C*H₃)₂); 46,1 (NN(*C*H₃)₂); 25,1 (b, NCH(CH₃)₂); 16,0 (C*C*H₂Si(CH₃)₃); - 0,2 (CCH₂Si(*C*H₃)₃). Das Signal des quartären C-Atoms des Amidinatoliganden ist wegen der Dynamik des Moleküls nicht zu sehen.

| | | | | |
|---|---|---|---|---|
| Elementaranalyse (%, C₂₄H₅₆N₆ClNbSi₂) | theoretisch: | C 47,00; | H 9,20; | N 13,70 |
| | gefunden: | C 46,80; | H 9,12; | N 13,54 |

EI-MS: 612 M⁺, 55; 213 (ⁱprN)₂CCH₂SiMe₃⁺, 55; 156 ⁱPrNCCH₂SiMe₃⁺, 85.
IR (Nujolverreibung): 1558m, 1498w, 1342m, 1261m, 1251m, 1209s, 1178m, 1143m, 1124m, 1097m, 1055m, 1018w, 866m, 895w, 850s, 837s, 800bw, 721w, 709w, 646w, 574w, 528w.

## Patentansprüche

1. Verbindungen der allgemeinen Formel (II) 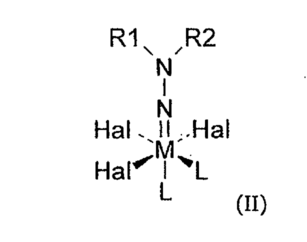 wobei
M für Nb oder Ta steht,
R¹ und R² unabhängig voneinander für gegebenenfalls substituierte C₁- bis C₁₂-Alkyl-, C₅- bis C₁₂-Cycloalkyl-, C₆- bis C₁₀-Aryl-Reste, 1-Alkenyl-, 2-Alkenyl- und 3-Alkenylreste stehen,
Hal für Halogen aus der Gruppe F, Cl, Br und I steht, und
L für einen über O, S oder N an das Metallatom koordinierenden organischen Kom- plexliganden steht.

2. Verbindungen gemäß Anspruch 1, **dadurch gekennzeichnet, dass** Hal für Cl oder Br steht.

3. Verbindungen gemäß Anspruch 1 oder 2, **dadurch gekennzeichnet, dass** die Liganden L gleiche oder verschiedene einzähnige oder zweizähnige Liganden darstellen.

## Claims

1. Compounds of the general formula (II) 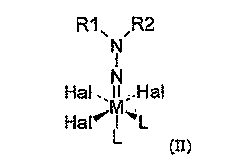 wherein
M stands for Nb or Ta,
R¹ and R² independently of one another stand for optionally substituted C₁ to C₁₂ alkyl, C₅ to C₁₂ cycloalkyl, C₆ to C₁₀ aryl radicals, 1-alkenyl, 2-alkenyl and 3-alkenyl radicals,
Hal stands for halogen from the group F, Cl, Br and I, and
L stands for an organic complex ligand coordinating via O, S or N to the metal atom.

2. Compounds according to claim 1, **characterised in that** Hal stands for Cl or Br.

3. Compounds according to claim 1 or 2, **characterised in that** the ligands L represent identical or different monodentate or bidentate ligands.

## Revendications

1. Composés de la formule générale (II) 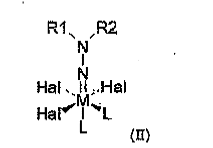 dans laquelle
M représente Nb ou Ta,
R¹ et R² représentent indépendamment l'un de l'autre des radicaux alkyles en C₁ à C₁₂, cycloalkyles en C₅ à C₁₂, aryles en C₆ à C₁₀, substitués le cas échéant, des radicaux 1-alcényles, 2-alcényles et 3-alcényles,
Hal représente un halogène du groupe F, Cl, Br et I, et
L représente un ligand complexant organique coordonné à l'atome métallique par O, S ou N.

2. Composés selon la revendication 1, **caractérisés en ce que** Hal représente Cl ou Br.

3. Composés selon la revendication 1 ou 2, **caractérisés en ce que** les ligands L représentent des ligands monodentates ou bidentates, identiques ou différents.
